# EUROPEAN PATENT APPLICATION

(11) **EP 4 425 591 A1**
(43) Date of publication of application: **04.09.2024**
(21) Application number: 24153643.2
(22) Date of filing: 24.01.2024
(51) Int. Cl.: H01M 4/04, H01M 10/04, H01M 10/052, H01M 10/0567, H01M 10/0587, H01M 10/44, H01M 10/615, H01M 4/02

(54) **NONAQUEOUS ELECTROLYTE SOLUTION SECONDARY BATTERY, AND MANUFACTURING METHOD AND INSPECTION METHOD FOR THE SAME**

(30) Priority: 02.03.2023 JP 2023031578
(71) Applicant: Prime Planet Energy & Solutions, Inc., Chuo-ku Tokyo 103-0022 (JP)
(72) Inventor: TSUKAMOTO, Kentaro, Tokyo, 103-0022 (JP)
(74) Representative: Kuhnen & Wacker Patent- und Rechtsanwaltsbüro PartG mbB

(57) **Abstract**

A nonaqueous electrolyte solution secondary battery (100) disclosed herein includes an electrode body (20) that includes a positive electrode (22) including a positive electrode active material layer (22a) and a negative electrode (24) including a negative electrode active material layer (24a), and a nonaqueous electrolyte solution. The negative electrode active material layer (24a) has a width of 15 cm or more and includes a film containing a boron element, and a black unevenness index is 12 or less.

## Description

### BACKGROUND OF THE DISCLOSURE

### 1. Field

The present disclosure relates to a nonaqueous electrolyte solution secondary battery, and a manufacturing method and an inspection method for the same.

### 2. Background

A nonaqueous electrolyte solution secondary battery that includes an electrode body including a positive electrode and a negative electrode, and a nonaqueous electrolyte solution has been known conventionally. In the nonaqueous electrolyte solution secondary battery, at initial charging, a part of the nonaqueous electrolyte solution is decomposed and a film including a decomposition product thereof (solid electrolyte interface film: SEI film) is deposited on a surface of a negative electrode active material layer. By this film, an interface between the negative electrode and the nonaqueous electrolyte solution is stabilized and thus, the battery performance can be improved. Conventional technical literatures related to this include Japanese Patent Application Publication No. 2007-250288 and Japanese Patent Application Publication No. 2022-154250.

For example, according to Japanese Patent Application Publication No. 2007-250288, an oxalato complex compound is added to a nonaqueous electrolyte solution and a predetermined aging process is performed, so that an initial output characteristic of a nonaqueous electrolyte solution secondary battery can be improved.

### SUMMARY

According to the present inventor's examination, however, in a case of applying the aforementioned technique to recent nonaqueous electrolyte solution secondary batteries with higher capacity, there is still room for improvement. That is to say, in the nonaqueous electrolyte solution secondary batteries with the higher capacity, for example, the width of an electrode body is as large as 15 cm or more, in which case an additive permeates less easily into a central part of the electrode body in a width direction. Accordingly, at initial charging, a film including a decomposition product of the additive is not formed easily on a surface of a negative electrode active material layer at the central part of the electrode body. That is to say, between the central part of the electrode body and the other part, unevenness occurs easily in terms of a formation state (for example, quantity or quality) of the film formed on a negative electrode. As a result, it has been found out newly that in the central part, the reactivity of the negative electrode becomes high and the thermal stability decreases locally, and for example, temperature increases easily at overcharging or the like.

The present disclosure has been made in view of the above circumstances, and an object is to provide a nonaqueous electrolyte solution secondary battery with improved thermal stability, and a manufacturing method and an inspection method for the same.

A nonaqueous electrolyte solution secondary battery according to the present disclosure includes an electrode body that includes a positive electrode including a positive electrode active material layer and a negative electrode including a negative electrode active material layer, a nonaqueous electrolyte solution, and a battery case that accommodates the electrode body and the nonaqueous electrolyte solution, in which the negative electrode active material layer has a width of 15 cm or more and includes a film containing a boron element, and a black unevenness index obtained by the following (procedure 1) to (procedure 7) is 12 or less. The black unevenness index is obtained by: (procedure 1) a surface of the negative electrode is photographed with a camera so as to include a central part of the negative electrode active material layer in a width direction and photographed image data expressed in an RGB color model is acquired; (procedure 2) a blue component of an RGB value is extracted from the photographed image data and converted into image data in grayscale with 256 tones in which black is 0 and white is 255; (procedure 3) a line profile in which an X axis represents a distance from one end part in the width direction and a Y axis represents a value in the 256 tones is extracted along the width direction of the negative electrode from the image data in grayscale; (procedure 4) the line profile is subjected to linear approximation, and by performing inclination correction with an obtained inclination, a first correction profile is created; (procedure 5) the first correction profile is subjected to second-order approximation, and by performing curve correction with an obtained second-order approximation equation, a second correction profile is created; (procedure 6) a central part of the X axis is extracted from the second correction profile so as to include a peak passing a minimum point where a value of the Y axis is minimum, the extracted central part is subjected to the linear approximation, and by performing the inclination correction with an obtained inclination, a third correction profile is created; and (procedure 7) when a part of the third correction profile excluding the peak passing the minimum point is a base part, an absolute value of a difference between an average value (base value) of the base part in the Y axis and the value of the minimum point in the Y axis is calculated as the black unevenness index.

The present inventor has found out that unevenness of a formation state of the film appears as color unevenness (black unevenness) in the central part of the negative electrode active material layer in the width direction. In addition, when the degree of the color unevenness (gradation) is defined as "black unevenness index" based on the aforementioned procedure, it has been discovered that there is a positive correlation between the black unevenness index and a heat generation quantity of the battery. That is to say, it has been discovered that, as the black unevenness index is larger (in other words, black is deeper), the heat generation quantity is larger and the thermal stability is lower. In view of this, the black unevenness index is adjusted to be less than or equal to a predetermined value in the present disclosure. Thus, the heat generation of the battery can be suppressed and the thermal stability can be improved. Therefore, the temperature increase at overcharging or the like can be suppressed. By using the objective numeral (black unevenness index) based on the photographed image data as an indicator, the accuracy varies less easily relatively compared to a case in which the color unevenness of the negative electrode active material layer is distinguished with human eyes, for example. Thus, the battery that can improve the thermal stability stably and has high reliability can be provided.

The present disclosure also provides a manufacturing method for a nonaqueous electrolyte solution secondary battery including an electrode body that includes a positive electrode including a positive electrode active material layer and a negative electrode including a negative electrode active material layer, a nonaqueous electrolyte solution, and a battery case that accommodates the electrode body and the nonaqueous electrolyte solution, in which the negative electrode active material layer has a width of 15 cm or more. This manufacturing method includes: a constructing step of constructing a battery assembly by accommodating the electrode body together with the nonaqueous electrolyte solution including a solvent, an electrolyte salt, and a compound containing a boron element in the battery case; an initial charging step of adjusting a state of charge (SOC) of the battery assembly to 5 to 50%; and an aging step of, after the initial charging step, leaving the battery assembly under a temperature condition of more than 50°C and 70°C or less for 24 hours or more while the state of charge is kept at 5 to 50%.

By including the aging step, it becomes easier to adjust the black unevenness index of the negative electrode active material layer and the black unevenness index can be suppressed suitably to a predetermine value or less. As a result, according to the present disclosure, the nonaqueous electrolyte solution secondary battery with excellent thermal stability and high reliability, in which heat generation is suppressed can be manufactured suitably.

Note that although there is no relation with the present disclosure, Japanese Patent Application Publication No. 2017-022067 discloses a manufacturing method in which a battery assembly that is charged to an SOC of 65% or more after initial charging is first subjected to low-temperature aging, that is, left at 15 to 30°C for 6 hours or more and then is subjected to high-temperature aging, that is, left at 60°C for 20 hours or more.

Moreover, an inspection method for a nonaqueous electrolyte solution secondary battery according to the present disclosure includes: a constructing step of constructing a battery assembly by accommodating, in a battery case, an electrode body in which a positive electrode including a positive electrode active material layer and a negative electrode including a negative electrode active material layer are stacked across a separator, and a nonaqueous electrolyte solution including a solvent, an electrolyte salt, and a compound containing a boron element; an initial charging step of adjusting a state of charge (SOC) of the battery assembly to 5 to 50%; an aging step of, after the initial charging step, leaving the battery assembly under a temperature condition of more than 50°C and 70°C or less for 24 hours or more while the state of charge is kept at 5 to 50%; a disassembling step of disassembling the battery assembly after the aging step; and a calculating step of, after the disassembling step, obtaining a black unevenness index of the negative electrode active material layer by the aforementioned (procedure 1) to (procedure 7).

The degree of heat generation of the battery can be predicted or confirmed with high accuracy by calculating the black unevenness index.

The above and other elements, features, steps, characteristics and advantages of the present disclosure will become more apparent from the following detailed description of the preferred embodiments with reference to the attached drawings.

### BRIEF DESCRIPTION OF THE DRAWINGS

FIG. 1 is a perspective view schematically illustrating a nonaqueous electrolyte solution secondary battery according to an embodiment;
FIG. 2 is a schematic longitudinal cross-sectional view taken along line II-II in FIG. 1;
FIG. 3 is a perspective view schematically illustrating an electrode body;
FIG. 4 is a schematic view illustrating a structure of the electrode body;
FIG. 5 expresses one example of a line profile;
FIG. 6 expresses a first-order approximation equation of the line profile in FIG. 5;
FIG. 7 expresses a first correction profile after inclination correction;
FIG. 8 expresses a second-order approximation equation of the first correction profile in FIG. 7;
FIG. 9 expresses a second correction profile after curve correction;
FIG. 10 expresses a first-order approximation equation of a partial extraction profile in which a part of FIG. 9 is extracted;
FIG. 11 expresses a third correction profile after inclination correction;
FIG. 12 is a graph expressing a relation between a black unevenness index and a heat generation quantity; and
FIG. 13 is a graph expressing a relation between a holding time (days) and the black unevenness index.

### DETAILED DESCRIPTION OF THE PREFERRED EMBODIMENTS

Hereinafter, some preferred embodiments of the art disclosed herein will be described with reference to the drawings. Note that matters other than matters particularly mentioned in the present specification and necessary for the implementation of the present disclosure (for example, the general configuration and manufacturing process of a nonaqueous electrolyte solution secondary battery that do not characterize the present disclosure) can be grasped as design matters of those skilled in the art based on the prior art in the relevant field. The present disclosure can be implemented on the basis of the disclosure of the present specification and common technical knowledge in the relevant field. Note that in the present specification, the notation "A to B" for a range signifies a value more than or equal to A and less than or equal to B, and is meant to encompass also the meaning of being "more than A" and "less than B".

In the present specification, the term "nonaqueous electrolyte solution secondary battery" refers to a general power storage device capable of being repeatedly charged and discharged by transfer of charge carriers between a positive electrode and a negative electrode through a nonaqueous electrolyte solution. The nonaqueous electrolyte solution secondary battery refers to a concept that encompasses a so-called storage battery such as a lithium ion secondary battery, and a capacitor such as a lithium ion capacitor and an electric double-layer capacitor.

### <Battery 100>

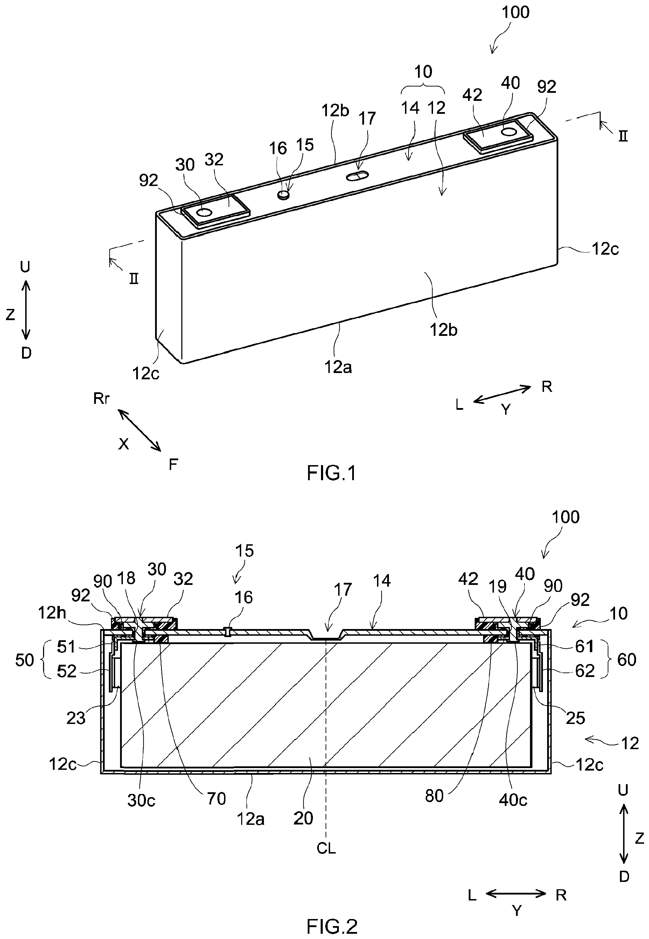

FIG. 1 is a perspective view of a nonaqueous electrolyte solution secondary battery (hereinafter, also referred to as a battery simply) 100. FIG. 2 is a schematic longitudinal cross-sectional view taken along line II-II in FIG. 1. In the following description, reference signs L, R, F, Rr, U, and D in the drawings respectively denote left, right, front, rear, up, and down, and reference signs X, Y, and Z in the drawings respectively denote a short side direction of the battery 100, a long side direction that is orthogonal to the short side direction, and an up-down direction that is orthogonal to the short side direction and the long side direction. These directions are defined however for convenience of explanation, and do not limit the manner in which the battery 100 is disposed.

As illustrated in FIG. 2, the battery 100 includes a battery case 10, an electrode body 20, a positive electrode terminal 30, a negative electrode terminal 40, a positive electrode current collecting part 50, a negative electrode current collecting part 60, a positive electrode insulating member 70, a negative electrode insulating member 80, and a nonaqueous electrolyte solution (not illustrated). The battery 100 is a lithium ion secondary battery here. The battery 100 is preferably the lithium ion secondary battery.

The battery case 10 is a housing that accommodates the electrode body 20 and the nonaqueous electrolyte solution. As illustrated in FIG. 1, the external shape of the battery case 10 here is a flat and bottomed cuboid shape (rectangular shape). A conventionally used material can be used for the battery case 10, without particular limitations. The battery case 10 is preferably made of a metal, and for example, more preferably made of aluminum, an aluminum alloy, iron, an iron alloy, or the like. As illustrated in FIG. 2, the battery case 10 includes an exterior body 12 having an opening 12h, and a sealing plate (lid body) 14 that covers the opening 12h. The battery case 10 preferably includes the exterior body 12 and the sealing plate 14.

As illustrated in FIG. 1, the exterior body 12 includes a bottom wall 12a with a substantially rectangular shape, a pair of long side walls 12b extending from long sides of the bottom wall 12a and facing each other, and a pair of short side walls 12c extending from short sides of the bottom wall 12a and facing each other. The bottom wall 12a faces the opening 12h. The long side wall 12b is larger in area than the short side wall 12c. Note that in the present specification, the term "substantially rectangular shape" encompasses, in addition to a perfect rectangular shape (rectangle), for example, a shape whose corner connecting a long side and a short side of the rectangular shape is rounded, a shape whose corner includes a notch, and the like.

As illustrated in FIG. 1, the sealing plate 14 is substantially rectangular in shape in a plan view. As illustrated in FIG. 2, the sealing plate 14 is attached to the exterior body 12 so as to cover the opening 12h of the exterior body 12. The sealing plate 14 faces the bottom wall 12a of the exterior body 12. The battery case 10 is unified in a manner that the sealing plate 14 is joined (for example, joined by welding) to a periphery of the opening 12h of the exterior body 12. The battery case 10 is hermetically sealed (closed).

As illustrated in FIG. 2, the sealing plate 14 is provided with a liquid injection hole 15, a gas discharge valve 17, and two terminal extraction holes 18 and 19. The liquid injection hole 15 is a hole for injecting the nonaqueous electrolyte solution after the sealing plate 14 is assembled to the exterior body 12. The sealing plate 14 is preferably provided with the liquid injection hole 15. The liquid injection hole 15 is sealed by a sealing member 16. The gas discharge valve 17 is configured to break when pressure inside the battery case 10 reaches a predetermined value or more and discharge a gas in the battery case 10 to the outside. The terminal extraction holes 18 and 19 are formed in both end parts of the sealing plate 14 in the long side direction Y (left end part and right end part in FIG. 2, respectively). The terminal extraction holes 18 and 19 penetrate the sealing plate 14 in a thickness direction (up-down direction Z). The terminal extraction holes 18 and 19 respectively have the inner diameters that enable penetration of the positive electrode terminal 30 and the negative electrode terminal 40 before the electrode terminals are attached to the sealing plate 14 (before a caulking process).

Each of the positive electrode terminal 30 and the negative electrode terminal 40 is fixed to the sealing plate 14 of the battery case 10. The positive electrode terminal 30 is disposed on one side of the sealing plate 14 in the long side direction Y (left side in FIG. 1 and FIG. 2). The negative electrode terminal 40 is disposed on the other side of the sealing plate 14 in the long side direction Y (right side in FIG. 1 and FIG. 2). As illustrated in FIG. 2, the positive electrode terminal 30 and the negative electrode terminal 40 are inserted to the terminal extraction holes 18 and 19 and extend to the outside from the inside of the sealing plate 14. The positive electrode terminal 30 and the negative electrode terminal 40 are preferably attached to the sealing plate 14. The positive electrode terminal 30 and the negative electrode terminal 40 are here caulked to a peripheral part of the sealing plate 14 that surrounds the terminal extraction holes 18 and 19 by the caulking process. Caulking parts 30c and 40c are formed at an end part of the positive electrode terminal 30 and the negative electrode terminal 40 on the exterior body 12 side (lower end part in FIG. 2).

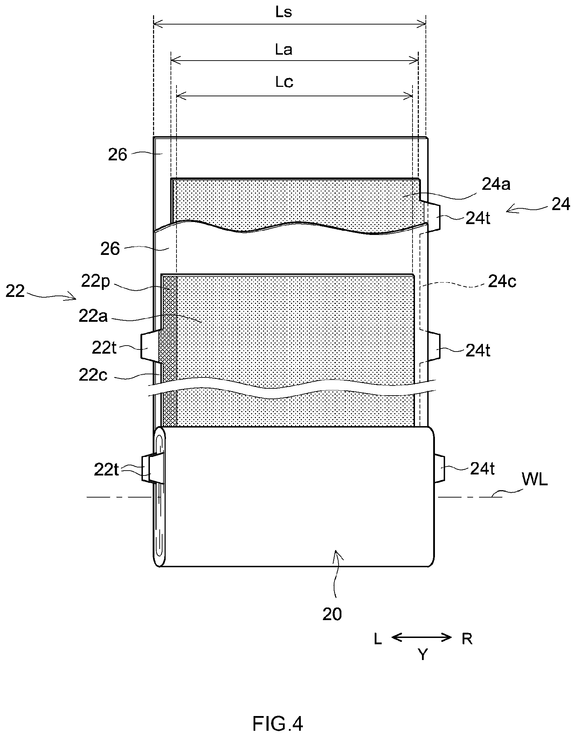

As illustrated in FIG. 2, the positive electrode terminal 30 is electrically connected to a positive electrode 22 (see FIG. 4, in detail, positive electrode tab group 23) of the electrode body 20 through the positive electrode current collecting part 50 inside the battery case 10. The positive electrode terminal 30 is insulated from the sealing plate 14 by the positive electrode insulating member 70 and a gasket 90. The positive electrode terminal 30 is preferably formed of a metal and is more preferably formed of, for example, aluminum or an aluminum alloy.

The negative electrode terminal 40 is electrically connected to a negative electrode 24 (see FIG. 4, in detail, negative electrode tab group 25) of the electrode body 20 through the negative electrode current collecting part 60 inside the battery case 10. The negative electrode terminal 40 is insulated from the sealing plate 14 by the negative electrode insulating member 80 and the gasket 90. The negative electrode terminal 40 is preferably formed of a metal and is more preferably formed of, for example, copper or a copper alloy. The negative electrode terminal 40 may be configured of two conductive members bonded together and integrated. In the negative electrode terminal 40, for example, a part connected to the negative electrode current collecting part 60 may be formed of copper or a copper alloy, and a part exposed on an outer surface of the sealing plate 14 may be formed of aluminum or an aluminum alloy.

A positive electrode external conductive member 32 and a negative electrode external conductive member 42, each having a plate shape, are attached to the outer surface of the sealing plate 14. The positive electrode external conductive member 32 and the negative electrode external conductive member 42 are members to which a busbar is attached when a plurality of the batteries 100 are electrically connected to each other. The positive electrode external conductive member 32 is electrically connected to the positive electrode terminal 30. The negative electrode external conductive member 42 is electrically connected to the negative electrode terminal 40. The positive electrode external conductive member 32 and the negative electrode external conductive member 42 are insulated from the sealing plate 14 by an external resin member 92. The positive electrode external conductive member 32 and the negative electrode external conductive member 42 are preferably formed of a metal and are more preferably formed of, for example, aluminum or an aluminum alloy. However, the positive electrode external conductive member 32 and the negative electrode external conductive member 42 are not always necessary and can be omitted in another embodiment.

As illustrated in FIG. 2, the electrode body 20 is accommodated inside the battery case 10 (in detail, inside the exterior body 12). The number of electrode bodies 20 to be disposed inside one battery case 10 is not limited in particular, and may be one, or two or more (plural). The electrode body 20 may be disposed inside the battery case 10 in a state of being covered with an electrode body holder with an insulating property. In other words, the electrode body holder may exist between the electrode body 20 and the battery case 10 (in detail, exterior body 12). For example, the electrode body holder may have a box shape, and the electrode body 20 may be disposed therein. The electrode body holder is preferably made of resin.

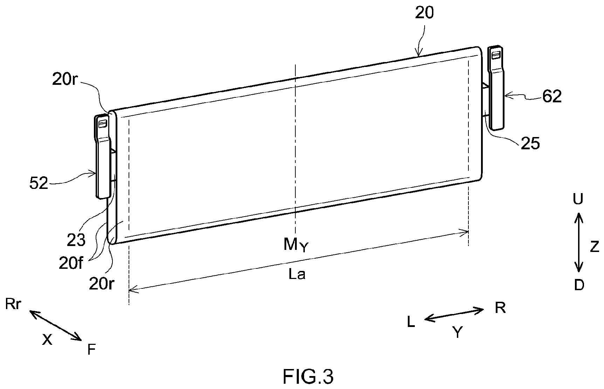

FIG. 3 is a perspective view schematically illustrating the electrode body 20. FIG. 4 is a schematic view illustrating a structure of the electrode body 20. As illustrated in FIG. 4, the electrode body 20 includes the positive electrode 22, the negative electrode 24, and a separator 26. The electrode body 20 here is a wound electrode body. The electrode body 20 has a structure in which the positive electrode 22 with a band shape and the negative electrode 24 with a band shape are stacked across the separator 26 with a band shape and wound using a winding axis WL as a center. Although not limited in particular, the number of winding turns of the electrode body 20 is preferably 20 turns or more, more preferably 30 turns or more, and still more preferably 50 turns or more, and may be 150 turns or less and 100 turns or less, for example.

The electrode body 20 is preferably the wound electrode body. As illustrated in FIG. 3, when the electrode body 20 is the wound electrode body, the nonaqueous electrolyte solution is supplied from only both end parts in the long side direction Y (winding axis WL direction). Thus, the nonaqueous electrolyte solution does not permeate easily sufficiently into a central part including a center M_{Y} in the long side direction Y (winding axis WL direction) in particular. Therefore, unevenness of a formation state (for example, quantity or quality) of a film easily occurs between the central part in the long side direction Y and the other part. Thus, it is particularly effective to apply the art disclosed herein.

As illustrated in FIG. 2 and FIG. 3, the electrode body 20 here is disposed inside the battery case 10 in a direction in which the winding axis WL is substantially parallel to the long side direction Y The winding axis WL direction is a width direction of the positive electrode 22, the negative electrode 24, and the separator 26, and a direction that coincides with the long side direction Y here. The electrode body 20 is disposed inside the battery case 10 in a direction in which the winding axis WL is parallel to the bottom wall 12a and orthogonal to the short side wall 12c. The battery 100 here has a so-called lateral tab structure in which the positive electrode tab group 23 and the negative electrode tab group 25 exist on both ends of the electrode body 20 in the winding axis WL direction (left and right ends in FIG. 2 and FIG. 3).

As illustrated in FIG. 3, the external shape of the electrode body 20 is a flat shape. The external shape of the electrode body 20 is preferably a flat shape. The electrode body 20 includes a pair of flat parts 20f expanding along the long side direction Y (the winding axis WL direction), and a pair of curved parts (R parts) 20r coupling the pair of flat parts 20f. The flat part 20f includes a flat outer surface (YZ plane in FIG. 3). The curved part 20r includes a curved outer surface. Note that in the present specification, "flat outer surface" is not limited to a perfectly flat surface, and is a term that encompasses a case in which a small step, curve, concave part, convex part, or the like is included when viewed microscopically, for example.

As illustrated in FIG. 1 to FIG. 3, the pair of flat parts 20f face the pair of long side walls 12b of the exterior body 12. The flat part 20f extends along the long side wall 12b. The pair of curved parts 20r face the bottom wall 12a of the exterior body 12 and the sealing plate 14. The electrode body 20 is preferably disposed inside the battery case 10 in a manner that the stacking direction (thickness direction) of the positive electrode 22 (see FIG. 4) and the negative electrode 24 (see FIG. 4) in the flat part 20f coincides with the short side direction X (direction perpendicular to the long side wall 12b), as described in this embodiment.

The positive electrode 22 may be similar to the conventional positive electrode, without particular limitations. As illustrated in FIG. 4, the positive electrode 22 includes a positive electrode current collector 22c, and a positive electrode active material layer 22a and a positive electrode protection layer 22p that are fixed on at least one surface of the positive electrode current collector 22c. However, the positive electrode protection layer 22p is not essential, and can be omitted in another embodiment. The positive electrode current collector 22c has a band shape. The positive electrode current collector 22c is formed of, for example, a conductive metal such as aluminum, an aluminum alloy, nickel, or stainless steel. Here, the positive electrode current collector 22c is a metal foil, specifically an aluminum foil.

At one end part of the positive electrode current collector 22c in the long side direction Y (left end part in FIG. 4), a plurality of positive electrode tabs 22t are provided. The plurality of positive electrode tabs 22t protrude toward one side in the long side direction Y (left side in FIG. 4). The plurality of positive electrode tabs 22t protrude in the long side direction Y relative to the separator 26. The positive electrode tab 22t constitutes a part of the positive electrode current collector 22c here, and is made of a metal foil (aluminum foil). At least a part of the positive electrode tab 22t is a current collector exposing part in which the positive electrode active material layer 22a and the positive electrode protection layer 22p are not formed and the positive electrode current collector 22c is exposed. As illustrated in FIG. 3, the plurality of positive electrode tabs 22t are stacked at one end part in the long side direction Y (left end part in FIG. 3), and form the positive electrode tab group 23. The positive electrode tab group 23 is electrically connected to the positive electrode terminal 30 through the positive electrode current collecting part 50. A positive electrode second current collecting part 52 of the positive electrode current collecting part 50 to be described below is attached (in detail, joined) to the positive electrode tab group 23.

As illustrated in FIG. 4, the positive electrode active material layer 22a is provided to have a band shape along a longitudinal direction of the positive electrode current collector 22c with a band shape. The positive electrode active material layer 22a contains a positive electrode active material (for example, a lithium transition metal complex oxide such as a lithium nickel cobalt manganese complex oxide) capable of reversibly storing and releasing the charge carriers. The positive electrode active material layer 22a may contain any component other than the positive electrode active material, for example, a conductive material, a binder, various additive components, or the like. As the conductive material, for example, a carbon material such as acetylene black (AB) can be used. As the binder, for example, polyvinylidene fluoride (PVdF) or the like can be used.

Although not limited in particular, in the battery 100 of a high-capacity type as illustrated in FIG. 4, which is used for vehicles or the like, the width of the positive electrode active material layer 22a in the winding axis WL direction (average value, excluding a part formed in the positive electrode tab 22t), in other words, a length Lc in the long side direction Y is preferably 15 cm or more, more preferably 20 cm or more, and still more preferably 25 cm or more.

The positive electrode protection layer 22p is provided between the positive electrode current collector 22c and the positive electrode active material layer 22a in the long side direction Y as illustrated in FIG. 4. Here, the positive electrode protection layer 22p is provided at one end part (left end part in FIG. 4) of the positive electrode current collector 22c in the long side direction Y The positive electrode protection layer 22p is formed to have a band shape along the positive electrode active material layer 22a. The positive electrode protection layer 22p contains inorganic filler (for example, alumina). The positive electrode protection layer 22p may contain an optional component other than the inorganic filler, such as a conductive material, a binder, or various additive components. The conductive material and the binder may be the same as those described as the examples that may be contained in the positive electrode active material layer 22a.

As illustrated in FIG. 4, the negative electrode 24 includes a negative electrode current collector 24c and a negative electrode active material layer 24a that is fixed on at least one surface of the negative electrode current collector 24c. The negative electrode current collector 24c has a band shape. The negative electrode current collector 24c is formed of, for example, a conductive metal such as copper, a copper alloy, nickel, or stainless steel. Here, the negative electrode current collector 24c is a metal foil, specifically a copper foil.

At one end part of the negative electrode current collector 24c in the long side direction Y (right end part in FIG. 4), a plurality of negative electrode tabs 24t are provided. Each of the plurality of negative electrode tabs 24t protrudes toward one side in the long side direction Y (right side in FIG. 4). The plurality of negative electrode tabs 24t protrude in the long side direction Y relative to the separator 26. The negative electrode tab 24t constitutes a part of the negative electrode current collector 24c and is made of a metal foil (copper foil). At least a part of the negative electrode tab 24t is a current collector exposing part in which the negative electrode active material layer 24a is not formed and the negative electrode current collector 24c is exposed. As illustrated in FIG. 3, the plurality of negative electrode tabs 24t are stacked at one end part in the long side direction Y (right end part in FIG. 3) and form the negative electrode tab group 25. The negative electrode tab group 25 is electrically connected to the negative electrode terminal 40 through the negative electrode current collecting part 60. A negative electrode second current collecting part 62 of the negative electrode current collecting part 60 to be described below is attached (in detail, joined) to the negative electrode tab group 25.

As illustrated in FIG. 4, the negative electrode active material layer 24a is provided to have a band shape along the longitudinal direction of the negative electrode current collector 24c with a band shape. The negative electrode active material layer 24a contains a negative electrode active material (for example, a carbon material such as graphite) capable of reversibly storing and releasing the charge carriers. When a total solid content of the negative electrode active material layer 24a is set to 100 mass%, the negative electrode active material may occupy approximately 80 mass% or more, typically 90 mass% or more, and for example 95 mass% or more. The negative electrode active material layer 24a may contain any component other than the negative electrode active material, for example, a binder, a dispersing agent, various additive components, or the like. As the binder, for example, rubbers such as styrene-butadiene rubber (SBR) can be used. As the dispersing agent, for example, celluloses such as carboxymethyl cellulose (CMC) can be used.

In the present embodiment, the negative electrode active material layer 24a includes a film (SEI film) containing a boron (B) element. This boron is a component derived from a film formation agent that is added to the nonaqueous electrolyte solution when the battery 100 is constructed, specifically a component derived from a boron-based additive. The aforementioned film is a decomposition product including the boron-based additive decomposed at initial charging. Thus, a battery characteristic (for example, output characteristic, cycle characteristic, durability, or the like) can be improved suitably. The presence of the film containing the boron element can be confirmed by, for example, detecting the B element through a conventionally known method such as inductively coupled plasma (ICP) spectrometry, ion chromatography, or X-ray absorption fine structure (XAFS).

As described above, in the electrode body 20 with higher capacity in recent years, the additive permeates less easily into the central part in the long side direction Y (winding axis WL direction, width direction). The present inventor's examination indicates that, because of this, the formation state (for example, quantity or quality) of the film in the central part in the long side direction Y is different from that in the other part and this difference appears as color unevenness (black unevenness). That is to say, the negative electrode active material layer 24a has the color unevenness (black unevenness). The present inventor defines and quantifies the degree (gradation) of this black unevenness as "black unevenness index" obtained in accordance with a predetermined procedure. Then, it has been understood that there is a positive correlation between this black unevenness index and the heat generation quantity of the battery 100, which will be described in detail in Examples below. Thus, in the present embodiment, the black unevenness index of the negative electrode active material layer 24a is 12 or less. Therefore, the thermal stability of the battery 100 can be improved by suppressing the heat generation in the central part in the long side direction Y Moreover, the temperature increase of the battery 100 at overcharging or the like can be suppressed.

Note that in the present specification, the term "black unevenness index" refers to a value obtained in accordance with the following (procedure 1) to (procedure 7) after the battery 100 is disassembled and the negative electrode 24 is extracted. That is to say, first, in (procedure 1), a surface of the negative electrode 24 is photographed with a camera so as to include the central part of the negative electrode active material layer 24a in the long side direction Y and photographed image data expressed in an RGB color model (Red-Green-Blue color model) is acquired. The photographing can be performed using, for example, a commercial digital camera. In the case where the electrode body 20 is the wound electrode body as described in this embodiment, it is preferable to photograph the central part in the short side direction X (the thickness direction orthogonal to the winding axis WL direction) where it is considered that the nonaqueous electrolyte solution permeates the least easily, for example the surface of the negative electrode 24 existing within five turns (for example, about at the third turn) from a winding start end part.

Next, in (procedure 2), only a blue component of an RGB value is extracted from the above photographed image data using, for example, commercial image analysis software and converted into image data in grayscale with 256 tones in which black is 0 and white is 255. Next, in (procedure 3), a line profile is extracted from the image data in grayscale along the long side direction Y of the negative electrode 24. The line profile is expressed by an X axis, which represents the distance from one end part in the long side direction Y, and a Y axis, which represents a value in 256 tones (gray values). In the case where the electrode body 20 is the flat wound electrode body as described in this embodiment, it is preferable to extract the line profile so as to include the central part of the flat part 20f (YZ plane in FIG. 3) where the nonaqueous electrolyte solution permeates less easily, that is, the central part in the long side direction Y (winding axis WL direction) and the central part in the up-down direction Z.

Next, in (procedure 4), first, the line profile is subjected to linear approximation (first-order approximation) to calculate a first-order approximation equation. Then, by performing inclination correction on the line profile with the inclination of the first-order approximation equation, a first correction profile is created. Next, in (procedure 5), first, the first correction profile is subjected to second-order approximation to calculate a second-order approximation equation. Then, by performing curve correction on the first correction profile with the obtained second-order approximation equation, a second correction profile is created. Subsequently, in (procedure 6), first, a predetermined range (for example, 50 pixels) of the central part in the long side direction Y is extracted from the aforementioned second correction profile so as to include a peak passing a minimum point where a value of the Y axis is the minimum (black is deepest), and a partial extraction profile is created. Next, the partial extraction profile is subjected to the linear approximation (first-order approximation) to calculate a first-order approximation equation. Then, by performing the inclination correction on the partial extraction profile with the inclination of the first-order approximation equation, a third correction profile is created. Subsequently, in (procedure 7), when a part of the third correction profile excluding the peak passing the minimum point is a base part, an absolute value of a difference between an average value (base value) of the base part in the Y axis and the value of the minimum point in the Y axis is calculated as the black unevenness index.

Note that the color unevenness (black unevenness) of the film can be recognized by human eyes, for example; however, since human eyes are different from individual to individual, it is assumed that the result of determining whether the color unevenness exists varies depending on the individuals. On the other hand, if the objective numerals (black unevenness index) based on the photographed image data as described in the art disclosed herein are used as an indicator, the accuracy varies less easily relatively. In addition, even the color difference that cannot be determined by the human eyes can be distinguished. Thus, the battery 100 that can improve the thermal stability stably and has high reliability can be provided.

From the viewpoint of achieving the effect of the art disclosed herein at the high level, the black unevenness index is preferably 10 or less, more preferably 9 or less, and still more preferably 8 or less. For example, in the battery 100 with higher capacity in recent years, the black unevenness index is typically 1 or more and 2 or more, and may be, for example, 4 or more, 5 or more, 6 or more, and 7 or more. In an aspect in which the black unevenness index is more than or equal to a predetermined value, it is particularly effective to apply the art disclosed herein. Note that the black unevenness index can be adjusted suitably not just by the liquid injection quantity of the nonaqueous electrolyte solution or the concentration of the additive (the compound containing the boron element) in the nonaqueous electrolyte solution when the battery 100 is constructed, but also by the conditions in an aging step (step 5) after the initial charging, especially a holding time in a manufacturing method to be described below, for example.

As illustrated in FIG. 4, the width of the negative electrode active material layer 24a in the winding axis WL direction (average value, excluding a part formed in the negative electrode tab 24t), in other words, a length La in the long side direction Y is typically more than or equal to the length Lc of the positive electrode active material layer 22a in the long side direction Y The length La is 15 cm or more from the viewpoints of increasing the capacity and the like. The length La is preferably 20 cm or more and more preferably 25 cm or more. As the length La is longer, the nonaqueous electrolyte solution permeates less easily into the central part in the long side direction Y, and the unevenness occurs more easily in the state of the film (for example, quantity or quality). Therefore, it is particularly effective to apply the art disclosed herein. The length La may be, for example, 100 cm or less and 50 cm or less. Thus, the effect of the art disclosed herein can be achieved at the high level.

As illustrated in FIG. 4, the separator 26 is a member that insulates the positive electrode active material layer 22a of the positive electrode 22 and the negative electrode active material layer 24a of the negative electrode 24 from each other. The width of the separator 26 in the winding axis WL direction, that is, a length Ls in the long side direction Y is typically more than or equal to the length La of the negative electrode active material layer 24a in the long side direction Y The separator 26 is preferably, for example, a porous sheet made of resin including polyolefin resin such as polyethylene (PE) or polypropylene (PP). The separator 26 may include a heat resistance layer (HRL) or an adhesive layer on a surface of a base material part formed by a porous sheet made of resin. For example, the heat resistance layer is a layer including inorganic filler and a binder. The adhesive layer is a layer including a binder. The structures of the heat resistance layer and the adhesive layer may be similar to the conventional structures thereof.

As illustrated in FIG. 2, the positive electrode current collecting part 50 forms a conductive path for electrically connecting the positive electrode terminal 30 and the positive electrode tab group 23 formed by the plurality of positive electrode tabs 22t. The positive electrode current collecting part 50 may be formed of the same metal species as the positive electrode current collector 22c, for example, a conductive metal such as aluminum, an aluminum alloy, nickel, or stainless steel. The positive electrode current collecting part 50 includes a positive electrode first current collecting part 51 and the positive electrode second current collecting part 52. The positive electrode first current collecting part 51 is attached to an inner surface of the sealing plate 14. The positive electrode second current collecting part 52 extends along the short side wall 12c of the exterior body 12. The positive electrode second current collecting part 52 is attached to the positive electrode tab group 23 of the electrode body 20.

As illustrated in FIG. 2, the negative electrode current collecting part 60 forms a conductive path for electrically connecting the negative electrode terminal 40 and the negative electrode tab group 25 formed by the plurality of negative electrode tabs 24t. The negative electrode current collecting part 60 may be formed of the same metal species as the negative electrode current collector 24c, for example, a conductive metal such as copper, a copper alloy, nickel, or stainless steel. The negative electrode current collecting part 60 includes a negative electrode first current collecting part 61 and the negative electrode second current collecting part 62. The structure and arrangement of the negative electrode first current collecting part 61 and the negative electrode second current collecting part 62 may be similar to those of the positive electrode first current collecting part 51 and the positive electrode second current collecting part 52 of the positive electrode current collecting part 50, respectively. The negative electrode second current collecting part 62 is attached to the negative electrode tab group 25 of the electrode body 20.

As illustrated in FIG. 2, the positive electrode insulating member 70 is a member that insulates the sealing plate 14 and the positive electrode first current collecting part 51. The positive electrode insulating member 70 is made of a resin material that has resistance against the electrolyte solution to be used and an electrical insulating property and that is capable of elastic deformation. The positive electrode insulating member 70 is preferably made of a polyolefin resin such as polypropylene (PP), a fluorinated resin such as tetrafluoroethylene-perfluoroalkoxy ethylene copolymer (PFA), or polyphenylene sulfide (PPS), for example.

As illustrated in FIG. 2, the negative electrode insulating member 80 is a member that insulates the sealing plate 14 and the negative electrode first current collecting part 61. The negative electrode insulating member 80 is disposed to be symmetrical to the positive electrode insulating member 70 about a center CL of the electrode body 20 in the long side direction Y The material, the structure, and the like of the negative electrode insulating member 80 may be similar to those of the positive electrode insulating member 70.

The nonaqueous electrolyte solution typically contains a nonaqueous solvent and an electrolyte salt (supporting salt). As the nonaqueous solvent, one kind or two or more kinds of nonaqueous solvents that have conventionally been known as being usable for the nonaqueous electrolyte solution secondary battery can be used. Examples of the nonaqueous solvent include organic solvents such as carbonates, ethers, esters, nitriles, sulfones, and lactones. The nonaqueous solvent preferably includes the carbonates. Examples of the carbonates include chain carbonates such as ethylene carbonate (EC), dimethyl carbonate (DMC), diethyl carbonate (DEC), and ethyl methyl carbonate (EMC) and cyclic carbonates such as propylene carbonate (PC).

The electrolyte salt is not limited to a particular type as long as the charge carriers (typically, lithium ion) are included, and one kind or two or more kinds of electrolyte salts that have conventionally been known as being usable for the nonaqueous electrolyte solution secondary battery can be used. One example of the electrolyte salt is fluorine-containing lithium salt such as LiPF₆ or LiBF₄. The electrolyte salt preferably contains LiPF₆.

The nonaqueous electrolyte solution may further contain an additional component (additive). As the additive, one kind or two or more kinds of additives that have conventionally been known as being able to be added to the nonaqueous electrolyte solution can be used. Examples of the additive include: the boron-based additive containing the boron element, such as lithium bisoxalate borate (LiBOB) or lithium difluoro(oxalato)borate (LiODFB); a phosphorus-based additive containing a phosphorus element, such as lithium difluorophosphate (LiPO₂F₂), lithium difluorooxalate phosphate (LiDFOP), or (lithium(fluorosulfonyl)(difluorophosphonyl)imide); a sulfur-based additive containing a sulfur element, such as lithium fluorosulfonate (LiSO₃F), lithium=ethyl=sulfate, lithium bis(trifluoromethanesulfonyl)imide (LiTFSI), lithium bis(fluorosulfonyl)imide (LiFSI), or (lithium(fluorosulfonyl)(difluorophosphonyl)imide); a carbonate-based additive containing a carbonate group (-O-(C=O)-O-), such as vinylene carbonate (VC), vinyl ethylene carbonate (VEC), or fluoroethylene carbonate (FEC); and the like. These additives may be so-called film formation agents that are decomposed before (at lower potential than) the nonaqueous solvent and/or the electrolyte salt at the initial charging and deposited as a film on the surface of the negative electrode active material layer 24a or the like.

The nonaqueous electrolyte solution preferably contains the boron-based additive (additive containing the boron element). Thus, the battery characteristic, for example, the output characteristic, the cycle characteristic (high output retention rate and/or high capacity retention rate), or the like can be improved suitably. The boron-based additive is preferably an oxalato complex compound containing the boron element (B element containing oxalato compound).

The nonaqueous electrolyte solution preferably further contains, in addition to the boron-based additive, at least one of the phosphorus-based additive, the sulfur-based additive, and the carbonate-based additive. In particular, it is preferable that the boron-based additive and the carbonate-based additive be used in combination. Thus, the battery characteristic, for example, the output characteristic, the cycle characteristic (high output retention rate and/or high capacity retention rate), or the like can be improved further.

Note that the additive in the nonaqueous electrolyte solution (for example, the boron-based additive, the phosphorus-based additive, the sulfur-based additive, or the carbonate-based additive described above) is typically decomposed electrically by the initial charging at the battery manufacture or the like and consumed to form the film on the negative electrode active material layer 24a or the like. Therefore, in the state of the battery 100, the additive as described above may be included (remain) or may not be included in the nonaqueous electrolyte solution.

### <Manufacturing method for battery 100>

For example, the battery 100 can be manufactured by a manufacturing method including the following steps in the following order: a constructing step for a battery assembly (step 1), an electrolyte solution impregnation step (step 2), an initial charging step (step 3), a liquid injection hole sealing step (step 4), and the aging step (step 5). However, the electrolyte solution impregnation step (step 2) is optional and can be omitted in another embodiment. In still another embodiment, the order of the liquid injection hole sealing step (step 4) and the aging step (step 5) may be opposite. Additionally, another step may be included at an optional stage.

In the constructing step (step 1), the electrode body 20 and the nonaqueous electrolyte solution are accommodated in the battery case 10 to construct the battery assembly in a glove box. In this specification, the term "battery assembly" refers to an intermediate object assembled up to the state before the initial charging step (step 3) is performed in the manufacturing process for the battery 100. The order of accommodating the electrode body 20 and the nonaqueous electrolyte solution in the battery case 10 is not limited in particular. For example, after the electrode body 20 is accommodated in the battery case 10, the nonaqueous electrolyte solution may be injected into the battery case 10.

In a preferred embodiment, the present step includes a disposing step (step 1-1), a welding joining step (step 1-2), a drying step (step 1-3), and a liquid injecting step (step 1-4) typically in this order. However, the drying step (step 1-3) is optional and can be omitted in another embodiment. In still another embodiment, the order of the welding joining step (step 1-2) and the drying step (step 1-3) may be opposite and the order of the welding joining step (step 1-2) and the liquid injecting step (step 1-4) may be opposite. In yet still another embodiment, the liquid injecting step (step 1-4) may be performed in multiple stages. Additionally, another step may be included at an optional stage.

In the disposing step (step 1-1), the electrode body 20 is disposed inside the exterior body 12. Specifically, the electrode body 20 is accommodated inside the exterior body 12 through the opening 12h. Next, in the welding joining step (step 1-2), the sealing plate 14 is welded at the periphery of the opening 12h of the exterior body 12 to integrate the exterior body 12 and the sealing plate 14. Then, in the drying step (step 1-3), the exterior body 12 accommodating the electrode body 20 is dried with the liquid injection hole 15 opened, so that the moisture inside the exterior body 12 is removed. In particular, the moisture inside the electrode body 20 is removed. The moisture is removed similarly to the conventional art using a heating and drying device, a vacuum drying device, or the like through operations of heating, decompression, and the like carried out alone or in combination. The heating temperature is preferably set so that the moisture can be evaporated suitably in a decompressed state and the separator of the electrode body 20 and the like do not thermally deteriorate, for example. The heating temperature can be set in the range of, for example, 50 to 200°C.

Next, in the liquid injecting step (step 1-4), first, the nonaqueous electrolyte solution is prepared. The nonaqueous electrolyte solution contains the boron-based additive in addition to the nonaqueous solvent and the electrolyte salt. Although not limited in particular, the ratio of the boron-based additive to the entire nonaqueous electrolyte solution is preferably 0.1 mass% or more and more preferably 0.5 mass% or more. On the other hand, from the viewpoint of suppressing the increase in battery resistance, the ratio of the boron-based additive to the entire nonaqueous electrolyte solution is preferably 5 mass% or less, more preferably 2 mass% or less, and still more preferably 1 mass% or less.

In addition to the boron-based additive, the nonaqueous electrolyte solution preferably contains another additive, for example, at least one of the phosphorus-based additive, the sulfur-based additive, and the carbonate-based additive described above. The concentration of each additive may be similar to that of the boron-based additive. The prepared nonaqueous electrolyte solution is injected into the battery case 10 through the liquid injection hole 15 of the sealing plate 14. The liquid is injected preferably with the inside of the battery case 10 decompressed in order to improve the impregnation of the electrode body 20 with the nonaqueous electrolyte solution.

In the electrolyte solution impregnation step (step 2), after the constructing step for the battery assembly (specifically, after the liquid injecting step), the electrolyte solution is permeated into the battery assembly. In this step, to promote the permeation, the battery assembly may be accommodated in a chamber in which the pressure can be regulated, and in a state where the liquid injection hole 15 is opened (in other words, a state where there is no pressure difference between the inside and the outside of the battery case 10), compression and/or decompression may be repeated a predetermined number of times. Thus, the inside of the electrode body 20, in particular the central part in the long side direction Y can be impregnated with the nonaqueous electrolyte solution sufficiently, and the unevenness of the film in the long side direction Y can be reduced further.

In a preferred aspect, the compression and pressure release are repeated a predetermined number of times. The pressure at the compression is preferably 0.5 MPa or more, and more preferably 0.8 MPa or more, for example, although depending on the length La of the negative electrode active material layer 24a in the long side direction Y or the like. The holding time in the compressed state is preferably five minutes or more and more preferably six minutes or more, for example, although depending on the length La of the negative electrode active material layer 24a in the long side direction Y or the like. After the compression, the pressure is released to return to the normal pressure (about 0 MPa); then, the holding time in the normal pressure state is preferably one minute or more. The number of times of repeating the compression and the pressure release is preferably 10 times or more, more preferably 15 times or more, and still more preferably 20 times or more. The present step may be performed in a normal temperature (about 25°C ± 10°C, 25°C ± 5°C, for example) environment.

In the initial charging step (step 3), the state of charge (SOC) of the battery assembly is adjusted to 5 to 50% after the electrolyte solution impregnation step. The battery assembly can be charged similarly to the conventional charging. Typically, an external power source is connected between the positive electrode terminal and the negative electrode terminal of the battery assembly, and charging is performed until a predetermined state of charge (SOC) is achieved. The state of charge (SOC) is not limited in particular as long as the SOC is 5 to 50%, and is preferably 10% or more and more preferably 15% or more from the viewpoint of stably securing the charging quantity necessary to decompose the additive. If charging is performed excessively in this step (in other words, before the film is formed in the aging step (step 5)), the decomposition of the solvent may be promoted; thus, the state of charge (SOC) is preferably 40% or less and more preferably 30% or less. The charging rate may be, for example, about 0.1 C to 2 C. For example, the charging may be performed once, or twice or more with the discharging conducted between the charging processes. The present step may be performed in the normal temperature (about 25°C ± 10°C, 25°C ± 5°C, for example) environment, and may be performed in a high-temperature environment of about 45°C, for example. By the charging in the high-temperature environment, the film formation can be promoted.

By the initial charging, the additive in the nonaqueous electrolyte solution (at least the boron-based additive) is electrolyzed before the other components (nonaqueous solvent or electrolyte salt) in the nonaqueous electrolyte solution typically. Thus, the film (SEI film) including the decomposition product of at least the boron-based additive is formed on the surface of the negative electrode active material layer 24a.

In the liquid injection hole sealing step (step 4), the liquid injection hole 15 is sealed with the sealing member 16. In a preferred aspect, first, after the initial charging step, the gas in the battery case 10, for example air, gas generated by the decomposition of the nonaqueous electrolyte solution in the initial charging step, and the like are discharged to the outside of the battery case 10. The gas can be discharged by, for example, decompressing the inside of the battery case 10. Next, in the state where the inside of the battery case 10 is kept at the normal pressure or decompressed, the battery case 10 is hermetically sealed (closed).

In the aging step (step 5), the battery assembly after the initial charging is held in a temperature environment of more than 50°C and 70°C or less for 24 hours or more while the state of charge (SOC) adjusted in the initial charging step (step 3), that is, an SOC of 5 to 50% is kept. Thus, the film formation of the negative electrode active material layer 24a can be promoted and the black unevenness index in the long side direction Y can be suitably adjusted to be the predetermined value or less. Therefore, the battery 100 with the excellent thermal stability and the high reliability, in which the heat generation is suppressed, can be manufactured suitably. Note that the present step may be started within about one day, for example within one hour, after the initial charging step (step 3) or the liquid injection hole sealing step (step 4), for example. The time for which the battery assembly is held in the temperature environment of 50°C or less after the initial charging step (step 3) or the liquid injection hole sealing step (step 4) is preferably within one day, for example within one hour.

Conventionally known heating means can be used as appropriate as a method of holding the battery assembly in the aforementioned temperature condition (high-temperature condition). For example, the battery assembly is accommodated in a thermostatic chamber (temperature controlled thermostatic chamber) set to a predetermined temperature, or the battery assembly is heated from the outside using heating means such as an infrared heater. The holding temperature of the battery assembly is not limited in particular as long as the holding temperature is more than 50°C and 70°C or less, and is preferably 60 to 70°C.

The present inventor's examination indicates that there is a negative correlation between the holding temperature in the present step and the black unevenness index of the negative electrode active material layer 24a, which will be described in detail in Examples below. That is to say, as the holding temperature in the present step increases, the black unevenness index tends to decrease. Therefore, the black unevenness index can be decreased efficiently by setting the holding temperature to a predetermined value or more. Moreover, the manufacturing efficiency can be increased by shortening the required time of the present step. Additionally, employing the aforementioned temperature range can promote the decomposition of the additive, which was not fully decomposed in the initial charging step (step 3), and can form the film with high quality on the surface of the negative electrode active material layer 24a. Thus, the battery 100 with the excellent thermal stability can be achieved.

The holding time of the battery assembly is not limited in particular as long as the holding time is 24 hours (one day) or more. The present inventor's examination indicates that there is a negative correlation between the holding time of the present step and the black unevenness index of the negative electrode active material layer 24a. That is to say, as the holding time extends, the black unevenness index tends to decrease. Therefore, although the holding time can vary depending on the length La of the negative electrode active material layer 24a in the long side direction Y, the conditions in the electrolyte solution impregnation step (step 2), and the like, the holding time is more preferably 48 hours (2 days) or more and still more preferably 72 hours (3 days) or more, for example. When the holding time is a predetermined length of time or more, the black unevenness index of the negative electrode active material layer 24a can be easily adjusted to be within the aforementioned range (for example, 12 or less). The holding time is preferably within 240 hours (10 days) and more preferably within 144 hours (6 days) from the viewpoint of the manufacturing efficiency.

The present step is preferably performed with the battery assembly restricted. Thus, entry of gas (for example, air or gas generated in the initial charging step (step 3)) into the electrode body 20 can be suppressed. In a preferred embodiment, first, a cell pressing machine including a pair of restriction plates is prepared. Next, the battery assembly after the initial charging is disposed between the pair of restriction plates so that the pair of long side walls 12b of the battery case 10 face the restriction plates, and in this state, a restriction load is applied to the battery assembly by the pressing machine from the short side direction X. The restriction load is preferably 0.5 kN or more, more preferably 1 to 15 kN, and still more preferably 3 to 10 kN. However, the present step may be performed in a state where the battery assembly is not restricted (unrestricted state). The battery 100 can be manufactured suitably as above.

### <Inspection method for battery 100>

The battery assembly or the battery 100 after step 1 to step 5 in the aforementioned manufacturing method is subjected to quality management about the thermal stability in the form of acceptance sampling, for example. In view of this, in an inspection method disclosed herein, the battery assembly is then subjected to the subsequent steps of a charging and discharging step (step 6) of charging and discharging the battery assembly, a disassembling step (step 7) of disassembling the battery assembly, and a calculating step (step 8) of calculating the black unevenness index of the negative electrode active material layer 24a in this order. However, the charging and discharging step (step 6) is optional and can be omitted in another embodiment. In the present embodiment, an evaluation step (step 9) of evaluating the thermal stability of the battery assembly is also performed. Additionally, another step may be included at an optional stage.

In the charging and discharging step (step 6), the battery assembly after the aging step is charged and discharged at least once. Although not limited in particular, in one example, the battery assembly is charged until the state of charge (SOC) becomes 80% or more, preferably 90% or more, and for example 100%, and the battery assembly is discharged until the state of charge (SOC) becomes 20% or less, preferably 10% or less, and for example 0%. The present step can be grasped as a capacity confirmation step of the battery assembly. The charging and discharging rate may be, for example, about 0.1 C to 2 C. The charging and discharging may be performed once, or may be repeated twice or more. The present step may be performed in the normal temperature (about 25°C ± 10°C, 25°C ± 5°C, for example) environment.

In the disassembling step (step 7), the battery assembly after the charging and discharging step (or the aging step) is disassembled. The battery assembly is preferably disassembled in a dry air (for example, with a dew point of about -50°C) atmosphere, for example in the glove box in order to avoid the degeneration of the negative electrode 24. The battery assembly can be disassembled in a manner that, for example, first, the battery case 10 is cut with a tool such as an end mill, a laser, or the like to separate the sealing plate 14 from the exterior body 12, and moreover the electrode body 20 is extracted from the inside of the exterior body 12. Moreover, the winding of the extracted electrode body 20 is unfastened, so that the electrode body 20 can be separated into the positive electrode 22, the negative electrode 24, and the separator 26.

In the calculating step (step 8), after the disassembling step, the black unevenness index of the negative electrode active material layer 24a is calculated in accordance with (procedure 1) to (procedure 7) described above. As described above, the positive correlation exists between the black unevenness index of the negative electrode active material layer 24a and the heat generation quantity of the battery 100. Therefore, by calculating the black unevenness index of the negative electrode active material layer 24a, the thermal stability (heat generation behavior) of the battery 100 can be predicted or confirmed. Moreover, the thermal stability (heat generation behavior) of the battery 100 can be grasped relatively simply, compared to a case where the heat generation quantity of the battery is directly measured with a calorimeter, for example,

In the evaluation step (step 9), the thermal stability of the battery assembly or the battery 100 is evaluated. In a preferred aspect, the correlation between the black unevenness index and the heat generation quantity of the battery 100 is represented by an expression (for example, approximate curve given in Example) or the like in advance by a preliminary test or the like, and by assigning the black unevenness index to the expression, the heat generation quantity of the battery 100 is predicted. In another preferred aspect, whether the product is good or bad is determined based on the black unevenness index of the negative electrode active material layer 24a. For example, the product is determined to be good when the black unevenness index of the negative electrode active material layer 24a is less than or equal to a predetermined value (for example, less than or equal to 12). In the battery assembly that is determined to be good in this case, the heat generation quantity can be suppressed and the variation in thermal stability can be made small. Thus, the upper limit of the heat generation quantity of the battery 100 can be controlled suitably and the battery 100 with high reliability can be supplied to the market.

### <Application of battery 100>

The battery 100 is usable in various applications, and can be suitably used as a motive power source for a motor (power source for driving) that is mounted in a vehicle such as a passenger car or a truck because of having the high capacity and the excellent thermal stability, for example. The vehicle is not limited to a particular type, and may be, for example, a plug-in hybrid electric vehicle (PHEV), a hybrid electric vehicle (HEV), or a battery electric vehicle (BEV). The battery 100 can also be suitably used as a battery pack in which the plurality of batteries 100 are arranged in a predetermined arrangement direction and a load is applied from the arrangement direction by a restriction mechanism.

Several Examples relating to the present disclosure will be explained below, but the present disclosure is not meant to be limited to these Examples.

### «Test Example I (correlation between black unevenness index and heat generation quantity of battery)»

First, in the constructing step (step 1), the wound electrode body with a flat shape and the nonaqueous electrolyte solution were accommodated in the battery case and thus, the battery assemblies (Example 1 to Example 6) were constructed. Note that all of the flat parts of the negative electrode active material layers had a length of 285 mm in the winding axis direction (width direction) and a length (height) of 90 mm in the up-down direction. Next, the nonaqueous electrolyte solution was prepared in a manner that 0.8 mass% of lithium bisoxalate borate (LiBOB) as the boron-based additive and 1.0 mass% of vinylene carbonate (VC) as the carbonate-based additive were added to a mixed solvent containing ethylene carbonate (EC), ethyl methyl carbonate (EMC), and dimethyl carbonate (DMC) at a volume ratio of 30:30:40, and furthermore LiPF₆ as the electrolyte salt was dissolved therein at a concentration of 1.15 mol/L.

Next, in the electrolyte solution impregnation step (step 2), the battery assembly was left until the electrolyte solution permeated into the entire electrode body. Subsequently, in the initial charging step (step 3), the battery assembly was charged at a constant current until an SOC of 12% (corresponding to voltage: 3.4 V). Next, in the liquid injection hole sealing step (step 4), the liquid injection hole was sealed by the sealing member in the state of the normal pressure inside the battery case. Next, in the aging step (step 5), the battery assembly to which a restriction load of 1 kN was applied was held in a 25°C-temperature environment for the holding time shown in Table 1. After that, in the charging and discharging step (step 6), the battery assembly was charged to an SOC of 90%, and then, the battery assembly was discharged to an SOC of 0%. Thus, the nonaqueous electrolyte solution secondary batteries (Example 1 to Example 6), which were different from each other in terms of only the holding time in the aging step, were constructed.

Next, in the disassembling step (step 7), the nonaqueous electrolyte solution secondary battery in each Example was disassembled in the glove box with an Ar atmosphere and the electrode body was extracted from the battery case. Then, the winding of the electrode body extracted from the battery case was unfastened, so that the positive electrode, the negative electrode, and the separator were separated.

### <Evaluation on black unevenness index>

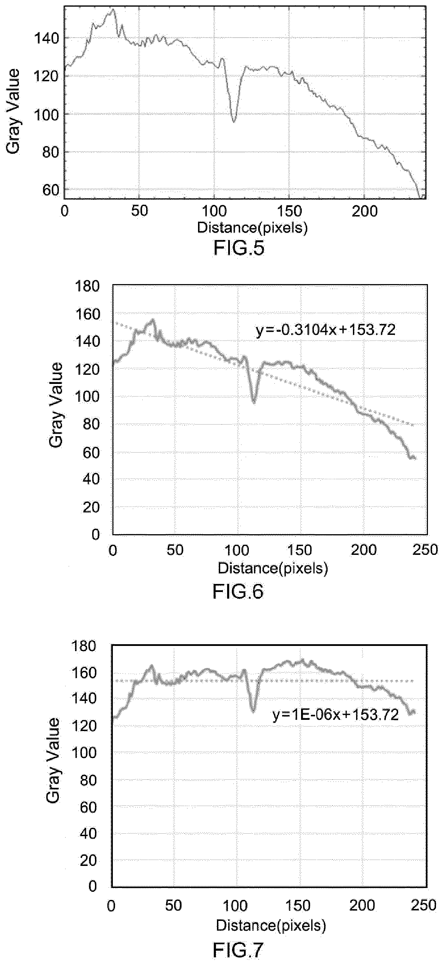

Next, in the calculating step (step 8), first, the surface of the negative electrode was photographed with a camera so as to include substantially the entire negative electrode active material layer in the width direction using a digital camera (PowerShot SX620 HS manufactured by Canon); thus, photographed image data in each Example was acquired (procedure 1). Note that a photographing position was set so as to include the central part (a central part in the width direction and a central part in the up-down direction) of the flat part existing in the third turn from the winding start end part. Next, the blue component of the RGB value was extracted from the aforementioned photographed image data using the commercial image analysis software, and converted into the image in grayscale with 256 tones in which black was 0 and white was 255 (procedure 2). Subsequently, the line profile (X axis: distance (pixels) from one end part in the width direction, Y axis: value in the aforementioned 256 tones (gray value)) was extracted along the width direction so as to include the central part in the width direction from the image data in grayscale (procedure 3). Note that an extraction position was the central part in the up-down direction here. FIG. 5 expresses one example of the line profile.

Next, the above line profile was subjected to the linear approximation to calculate the first-order approximation equation. FIG. 6 shows the approximation equation of the line profile in FIG. 5. In this example, the first-order approximation equation was y = -0.3104x + 153.72. Then, with the obtained inclination (-0.3104), the line profile was subjected to the inclination correction. Specifically, the product of the inclination (-0.3104) and the value of the X axis was subtracted from the value of each point of the line profile in the Y axis in FIG. 5. Thus, the first correction profile was created (procedure 4). FIG. 7 expresses the first correction profile.

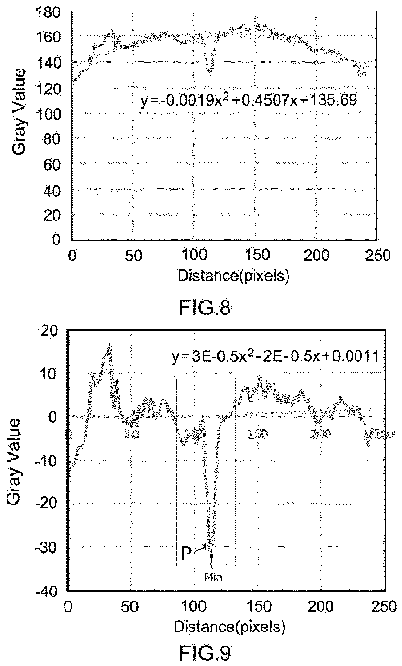

Next, the above first correction profile was subjected to second-order approximation to calculate the second-order approximation equation. FIG. 8 expresses the second-order approximation equation of the first correction profile in FIG. 7. In this example, the second-order approximation equation was y = -0.0019x² + 0.4507x + 135.69. Then, with the obtained second-order approximation equation, the first correction profile was subjected to the curve correction. Specifically, the value obtained by assigning each value of X axis to the second-order approximation equation was subtracted from the value of each point of the line profile in the Y axis in FIG. 7. Thus, the second correction profile was created (procedure 5). FIG. 9 expresses the second correction profile.

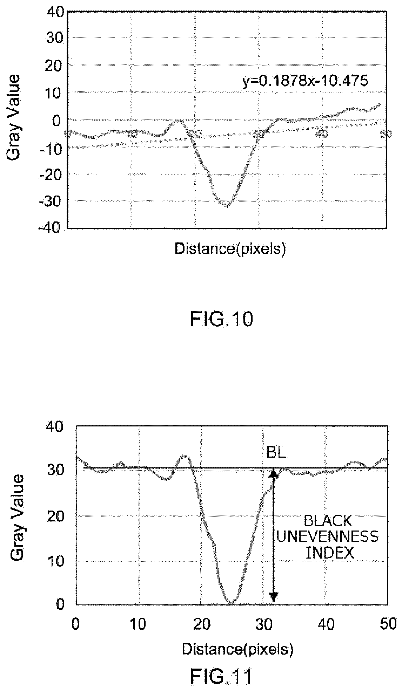

Next, the central part (within the frame in FIG. 9) of the X axis corresponding to 50 pixels was extracted from the second correction profile so as to include a peak P passing a minimum point Min where the value of the Y axis was minimum, using the minimum point Min as a center. Then, the value of the minimum point Min in the Y axis was aligned with a zero point and additionally, the value of the minimum point Min in the X axis was aligned with a center, so that the partial extraction profile was created. FIG. 10 expresses the partial extraction profile in FIG. 9. Next, the aforementioned partial extraction profile was subjected to the linear approximation to calculate the first-order approximation equation. FIG. 9 also expresses the approximation equation. In this example, the first-order approximation equation was y = 0.1878x - 10.475. Then, with the obtained inclination (0.1878), the partial extraction profile was subjected to the inclination correction. Specifically, the product of the inclination (0.1878) and the value of the X axis was subtracted from the value of each point of the line profile in the Y axis in FIG. 10. Thus, the third correction profile was created (procedure 6). FIG. 11 expresses the third correction profile. Next, when a part of the third correction profile excluding the peak P is the base part, an absolute value of a difference between an average value (base value, BL in FIG. 11) of the base part in the Y axis and the value of the minimum point in the Y axis is calculated as the black unevenness index (procedure 7). The results are shown in Table 1.

### <Evaluation on heat generation quantity>

First, the positive electrode active material layer and the negative electrode active material layer were cut out into a square of 30 mm × 30 mm from the central part of the flat part of the electrode body (the central part in the width direction and the central part in the up-down direction). Next, a sheet of the positive electrode active material layer (a square of 30 mm × 30 mm), a sheet of the negative electrode active material layer (a square of 30 mm × 30 mm), and 250 µL of the electrolyte solution were accommodated in a sample container. The nonaqueous electrolyte solution was prepared in a manner that LiPF₆ as the electrolyte salt was dissolved at a concentration of 1.1 mol/L in a mixed solvent containing ethylene carbonate (EC), dimethyl carbonate (DMC), and ethyl methyl carbonate (EMC) at a volume ratio of EC:DMC:EMC = 3:4:3 (the additive was not added).

Next, this sample container was sealed by pressing at 20 MPa and then set to a calvet calorimeter (model type: CALVET HT manufactured by SETARAM) together with a standard material (Al₂O₃, 2 mg). Then, the temperature was increased from 25°C to 400°C in accordance with the following temperature increase program in an inert atmosphere, and the heat generation quantity (J) between 75 to 200°C was obtained by integration. The results are shown in Table 1.

[Temperature increase program] 434 minutes in total
(1) 25°C to 30°C with a temperature increasing speed of 1.5 °C/min (4 minutes)
(2) 30°C is kept (60 minutes)
(3) 30°C to 400°C with a temperature increasing speed of 1 °C/min (370 minutes)

### <Evaluation on organic film quantity>

The negative electrode active material layer was cut out into a square of 30 mm × 30 mm from the central part of the flat part of the electrode body (the central part in the width direction and the central part in the up-down direction) and immersed in water, and the components were extracted. After this extracted solution was filtered, the organic film quantity was measured under the following condition in a nuclear magnetic resonance (NMR) apparatus. The results are shown in Table 1.
Apparatus: 600 MHz NMR manufactured by JEOL Ltd.
Measurement condition: 1H-NMR

### [Table 1]

**Table 1**

| | Holding time (hours (days)) at 25°C in aging step | Negative electrode active material layer | | Battery heat generation quantity (J) |
|---|---|---|---|---|
| | | Black unevenness index | Organic film quantity (µmol/cm²) | |
| Example 1 | 0 | 19 | 7.8 | 43 |
| Example 2 | 24 hours (1 day) | 17 | 7.0 | 29 |
| Example 3 | 48 hours (2 days) | 14 | 5.8 | 24 |
| Example 4 | 72 hours (3 days) | 14 | 5.8 | 27 |
| Example 5 | 96 hours (4 days) | 9 | 3.8 | 18 |
| Example 6 | 144 hours (6 days) | 6 | 2.6 | 16 |

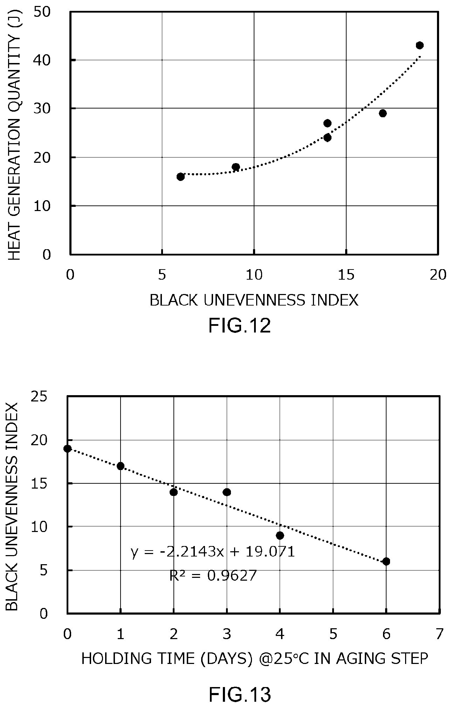

FIG. 12 expresses the relation between the black unevenness index of the negative electrode active material layer and the heat generation quantity of the battery. As expressed in FIG. 12, a positive correlation was observed between the black unevenness index and the heat generation quantity. In the case where the black unevenness index was small (in other words, black was light), the heat generation quantity was small and the thermal stability was high. In addition, here, it has been discovered that when the black unevenness index is 12 or less based on the aforementioned approximate curve, the heat generation quantity can be suppressed to about 20 J or less and the thermal stability of the battery can be improved.

FIG. 13 expresses the relation between the holding time (days) and the black unevenness index. As expressed in FIG. 13, as the holding time in the aging step (step 5) extended, the black unevenness index of the negative electrode active material layer decreased. That is to say, a negative correlation was observed between the holding time and the black unevenness index. Therefore, it has been found out that the black unevenness index can be suitably adjusted by the length of the holding time in the aging step. In the case where the holding temperature in the aging step is 25°C, it has been considered that the holding time needs to be 3.5 days or more in order to make the black unevenness index 12 or less.

Moreover, it has been discovered that as the black unevenness index is large, the organic film quantity is large as shown in Table 1. In addition, a very strong positive correlation of R² = 1 was confirmed between the black unevenness index and the organic film quantity. The organic film quantity is considered to be caused by the side reaction such as the decomposition of the solvent component. Thus, it has been presumed that if the holding time in the aging step is deficient and aging is insufficient, the organic film quantity increases and the "quality" of the film deteriorates and as a result, the black unevenness index increases (black becomes deeper) and the thermal stability decreases.

### «Test Example II (Example 7 to Example 9)»

When the holding temperature in the aging step was 25°C, the holding time needed to be 3.5 days or more in order to make the black unevenness index 12 or less; thus, the holding temperature in the aging step was 60°C for the purpose of improving the manufacturing efficiency in this test example. The black unevenness index of the negative electrode active material layer was calculated in a manner similar to Test Example I except that the battery assembly was held for the holding time shown in Table 2. The results are shown in Table 2.

### [Table 2]

**Table 2**

| | Holding time (hours (days)) at 60°C in aging step | Negative electrode active material layer |
|---|---|---|
| | | Black unevenness index |
| Example 7 | 24 hours (1 day) | 10 |
| Example 8 | 72 hours (3 days) | 8 |
| Example 9 | 144 hours (6 days) | 5 |

As shown in Table 2, when the holding temperature in the aging step was 60°C, the black unevenness index was able to be decreased in a very short time compared to the case of 25°C. That is to say, the manufacturing efficiency was able to be improved drastically. When the holding temperature in the aging step was 60°C, a holding time of 24 hours (1 day) or more enabled the black unevenness index to be 10 or less as shown in Example 7 and a holding time of 72 hours (3 days) or more enabled the black unevenness index to be much lower, which was 8 or less as shown in Example 8.

Although some embodiments of the present disclosure have been described above, these embodiments are just examples. The present disclosure can be implemented in various other modes. The present disclosure can be implemented based on the contents disclosed in this specification and the technical common sense in the relevant field. The techniques described in the scope of claims include those in which the embodiments exemplified above are variously modified and changed. For example, a part of the aforementioned embodiment can be replaced by another modified example, and the other modified example can be added to the aforementioned embodiment. Additionally, the technical feature may be deleted as appropriate unless such a feature is described as an essential element.

For example, in the aforementioned embodiment, the electrode body 20 is the wound electrode body. However, the present disclosure is not limited to this example. In another embodiment, the electrode body 20 may be a stack type electrode body formed in a manner that a plurality of square positive electrodes and a plurality of square negative electrodes are stacked in the insulated state across the separator. In this case, "the central part in the width direction" into which the electrolyte solution does not permeate easily is a central part in a width direction of one side of the square (in a case of a rectangular shape, preferably long side direction).

For example, in the aforementioned embodiment, the electrode body 20 has a so-called lateral tab structure in which the positive electrode tab group 23 and the negative electrode tab group 25 exist on both ends in the winding axis WL direction, and the electrode body 20 is accommodated in the battery case 10 so that the winding axis WL direction coincides with the long side direction Y However, the present disclosure is not limited to this example. In another embodiment, the battery 100 may have a so-called upper tab structure in which the positive electrode tab group 23 and the negative electrode tab group 25 exist on one end of the electrode body 20 in the winding axis WL direction (for example, upper end in FIG. 2 and FIG. 3). In this case, the winding axis WL direction may be a direction that coincides with the up-down direction Z. In this case, "the central part in the width direction" into which the electrolyte solution does not permeate easily is the central part in the up-down direction Z.

As described above, the following items are given as specific aspects of the art disclosed herein.
Item 1: The nonaqueous electrolyte solution secondary battery including the electrode body that includes the positive electrode including the positive electrode active material layer and the negative electrode including the negative electrode active material layer, the nonaqueous electrolyte solution, and the battery case that accommodates the electrode body and the nonaqueous electrolyte solution, in which the negative electrode active material layer has a width of 15 cm or more and includes the film containing the boron element, and the black unevenness index obtained by the aforementioned (procedure 1) to (procedure 7) is 12 or less.
Item 2: The nonaqueous electrolyte solution secondary battery according to Item 1, in which the electrode body is the wound electrode body in which the positive electrode with a band shape and the negative electrode with a band shape are stacked across the separator with a band shape and wound, and the negative electrode active material layer has a width of 15 cm or more in the winding axis direction of the wound electrode body.
Item 3: The nonaqueous electrolyte solution secondary battery according to Item 1 or 2, in which the nonaqueous electrolyte solution includes the additive containing the boron element.
Item 4: The nonaqueous electrolyte solution secondary battery according to any one of Items 1 to 3, in which the black unevenness index is 5 or more.
Item 5: The manufacturing method for the nonaqueous electrolyte solution secondary battery including the electrode body that includes the positive electrode including the positive electrode active material layer and the negative electrode including the negative electrode active material layer, the nonaqueous electrolyte solution, and the battery case that accommodates the electrode body and the nonaqueous electrolyte solution, in which the negative electrode active material layer has a width of 15 cm or more, the manufacturing method including: the constructing step of constructing the battery assembly by accommodating the electrode body together with the nonaqueous electrolyte solution including the solvent, the electrolyte salt, and the compound containing the boron element in the battery case; the initial charging step of adjusting the state of charge (SOC) of the battery assembly to 5 to 50%; and the aging step of, after the initial charging step, leaving the battery assembly under the temperature condition of more than 50°C and 70°C or less for 24 hours or more while the state of charge is kept at 5 to 50%.
Item 6: The manufacturing method for the nonaqueous electrolyte solution secondary battery according to Item 5, in which the temperature condition in the aging step is 60°C or more and 70°C or less.
Item 7: The inspection method for the nonaqueous electrolyte solution secondary battery, including: the constructing step of constructing the battery assembly by accommodating, in the battery case, the electrode body in which the positive electrode including the positive electrode active material layer and the negative electrode including the negative electrode active material layer are stacked across the separator, and the nonaqueous electrolyte solution including the solvent, the electrolyte salt, and the compound containing the boron element; the initial charging step of adjusting the state of charge (SOC) of the battery assembly to 5 to 50%; the aging step of, after the initial charging step, leaving the battery assembly under the temperature condition of more than 50°C and 70°C or less for 24 hours or more while the state of charge is kept at 5 to 50%; the disassembling step of disassembling the battery assembly after the aging step; and the calculating step of, after the disassembling step, obtaining the black unevenness index of the negative electrode active material layer by the aforementioned (procedure 1) to (procedure 7).

### [Reference Signs List]

10 Battery case
20 Electrode body (wound electrode body)
22 Positive electrode
24 Negative electrode
24a Negative electrode active material layer
24c Negative electrode current collector
26 Separator
100 Battery

## Claims

1. A nonaqueous electrolyte solution secondary battery (100) comprising an electrode body (20) that includes a positive electrode (22) including a positive electrode active material layer (22a) and a negative electrode (24) including a negative electrode active material layer (24a), a nonaqueous electrolyte solution, and a battery case (10) that accommodates the electrode body (20) and the nonaqueous electrolyte solution, wherein
the negative electrode active material layer (24a) has a width of 15 cm or more and includes a film containing a boron element, and
a black unevenness index obtained by the following (procedure 1) to (procedure 7) is 12 or less:
(procedure 1) a surface of the negative electrode (24) is photographed with a camera so as to include a central part of the negative electrode active material layer (24a) in a width direction and photographed image data expressed in an RGB color model is acquired;
(procedure 2) a blue component of an RGB value is extracted from the photographed image data and converted into image data in grayscale with 256 tones in which black is 0 and white is 255;
(procedure 3) a line profile in which an X axis represents a distance from one end part in the width direction and a Y axis represents a value in the 256 tones is extracted along the width direction of the negative electrode (24) from the image data in grayscale;
(procedure 4) the line profile is subjected to linear approximation, and by performing inclination correction with an obtained inclination, a first correction profile is created;
(procedure 5) the first correction profile is subjected to second-order approximation, and by performing curve correction with an obtained second-order approximation equation, a second correction profile is created;
(procedure 6) a central part of the X axis is extracted from the second correction profile so as to include a peak passing a minimum point where a value of the Y axis is minimum, the extracted central part is subjected to the linear approximation, and by performing the inclination correction with an obtained inclination, a third correction profile is created; and
(procedure 7) when a part of the third correction profile excluding the peak passing the minimum point is a base part, an absolute value of a difference between an average value (base value) of the base part in the Y axis and the value of the minimum point in the Y axis is calculated as the black unevenness index.

2. The nonaqueous electrolyte solution secondary battery (100) according to claim 1, wherein
the electrode body (20) is a wound electrode body in which the positive electrode (22) with a band shape and the negative electrode (24) with a band shape are stacked across a separator (26) with a band shape and wound, and
the negative electrode active material layer (24a) has a width of 15 cm or more in a winding axis direction of the wound electrode body (20).

3. The nonaqueous electrolyte solution secondary battery (100) according to claim 1 or 2, wherein the nonaqueous electrolyte solution includes an additive containing the boron element.

4. The nonaqueous electrolyte solution secondary battery (100) according to any one of claims 1 to 3, wherein the black unevenness index is 5 or more.

5. A manufacturing method for a nonaqueous electrolyte solution secondary battery (100) including an electrode body (20) that includes a positive electrode (22) including a positive electrode active material layer (22a) and a negative electrode (24) including a negative electrode active material layer (24a), a nonaqueous electrolyte solution, and a battery case (10) that accommodates the electrode body (20) and the nonaqueous electrolyte solution, in which the negative electrode active material layer (24a) has a width of 15 cm or more, the manufacturing method comprising:
a constructing step of constructing a battery assembly by accommodating the electrode body (20) together with the nonaqueous electrolyte solution including a solvent, an electrolyte salt, and a compound containing a boron element in the battery case (10);
an initial charging step of adjusting a state of charge (SOC) of the battery assembly to 5 to 50%; and
an aging step of, after the initial charging step, leaving the battery assembly under a temperature condition of more than 50°C and 70°C or less for 24 hours or more while the state of charge is kept at 5 to 50%.

6. The manufacturing method for the nonaqueous electrolyte solution secondary battery (100) according to claim 5, wherein the temperature condition in the aging step is 60°C or more and 70°C or less.

7. An inspection method for a nonaqueous electrolyte solution secondary battery (100), comprising:
a constructing step of constructing a battery assembly by accommodating, in a battery case (10), an electrode body (20) in which a positive electrode (22) including a positive electrode active material layer (22a) and a negative electrode (24) including a negative electrode active material layer (24a) are stacked across a separator (26), and a nonaqueous electrolyte solution including a solvent, an electrolyte salt, and a compound containing a boron element;
an initial charging step of adjusting a state of charge (SOC) of the battery assembly to 5 to 50%;
an aging step of, after the initial charging step, leaving the battery assembly under a temperature condition of more than 50°C and 70°C or less for 24 hours or more while the state of charge is kept at 5 to 50%;
a disassembling step of disassembling the battery assembly after the aging step; and
a calculating step of, after the disassembling step, obtaining a black unevenness index of the negative electrode active material layer (24a) by the following (procedure 1) to (procedure 7):
(procedure 1) a surface of the negative electrode (24) is photographed with a camera so as to include a central part of the negative electrode active material layer (24a) in a width direction and photographed image data expressed in an RGB color model is acquired;
(procedure 2) a blue component of an RGB value is extracted from the photographed image data and converted into image data in grayscale with 256 tones in which black is 0 and white is 255;
(procedure 3) a line profile in which an X axis represents a distance from one end part in the width direction and a Y axis represents a value in the 256 tones is extracted along the width direction of the negative electrode (24) from the image data in grayscale;
(procedure 4) the line profile is subjected to linear approximation, and by performing inclination correction with an obtained inclination, a first correction profile is created;
(procedure 5) the first correction profile is subjected to second-order approximation, and by performing curve correction with an obtained second-order approximation equation, a second correction profile is created;
(procedure 6) a central part of the X axis is extracted from the second correction profile so as to include a peak passing a minimum point where a value of the Y axis is minimum, the extracted central part is subjected to the linear approximation, and by performing the inclination correction with an obtained inclination, a third correction profile is created; and
(procedure 7) when a part of the third correction profile excluding the peak passing the minimum point is a base part, an absolute value of a difference between an average value (base value) of the base part in the Y axis and the value of the minimum point in the Y axis is calculated as the black unevenness index.
